Europäisches Patentamt

European Patent Office

Office européen des brevets

(11) Publication number: 0 428 983 A2

# EUROPEAN PATENT APPLICATION

(21) Application number: 90121717.4

(22) Date of filing: 13.11.90

(51) Int. Cl.5: H01L 21/00

(30) Priority: 13.11.89 US 435097

(43) Date of publication of application:
29.05.91 Bulletin 91/22

(84) Designated Contracting States:
BE CH DE ES FR GB IT LI NL

(71) Applicant: APPLIED MATERIALS, INC.
P.O. Box 58039 3050 Bowers Avenue
Santa Clara California 95052(US)

(72) Inventor: Liu, Benjamin Y.H.
1 North Deep Lake Road
North Oaks, Minnesota 55127(US)
Inventor: Ahn, Kang Ho
1611 Pleasant Street, Apt. 208
Lauderdale, Minnesota 55108(US)

(74) Representative: Diehl, Hermann Dr.
Diehl & Glaeser, Hiltl & Partner
Flüggenstrasse 13
W-8000 München 19(DE)

(54) Particle removal from surfaces by pressure change.

(57) This invention provides methods and apparatus for removing contaminant particles from a surface of an article (113). In one embodiment, a surface of an article (120) to be cleaned is immersed in cleaning liquid (117) in a pressure vessel chamber (115) and a dissolving gas (119) is dissolved into the cleaning liquid (117) at high pressure. A pressure relief valve (123) is then suddenly opened, bubbles spontaneously form in the liquid, and the contaminants are dislodged from the surface of the article (113) and carried toward the surface of the liquid (117) by the bubbles. A small amount of the cleaning liquid containing the dissolved gas can further be caused to form a thin frozen layer (120) on the surface of a submerged article to be cleaned, before the chamber pressure is then dropped suddenly, causing a spontaneous bubble formation in the frozen layer that moves the contaminant particles away from the surface to be cleaned. The contaminants and cleaning liquid or the frozen layer are then removed from the surface.

FIG.-6

## PARTICLE REMOVAL FROM SURFACES BY PRESSURE CHANGE

This application relates to a process and system for removing particulate matter from article surfaces.

In the manufacture of semiconductor wafers, current yields in commercial operations are often of the order of twenty to thirty percent, especially where manufacture of the particular wafer has not yet reached a mature state. A major reason for the low yield in commercial semiconductor wafer manufacture is the inability to achieve uniform and consistent cleanliness during the manufacturing process. For example, on many semiconductor devices, the distance of separation between adjacent electrically conductive paths of a circuit may be of the order of one micron or less, often as low as 0.25 $\mu$m in some experimental devices. By way of comparison, a human hair typically has a diameter of seventy microns. In semiconductor integrated circuit manufacture, an empirically established "twenty percent rule" requires that, if a critical dimension of a circuit is x $\mu$m, all contaminant particles of the size exceeding 0.2x $\mu$m should be removed from the circuit in order to reasonably assure acceptable operation of the circuit.

Various methods have been employed in the field of precision cleaning of wafers and similar substrates, such as ultrasonics, megasonics, wiping, brush scrubbing, low pressure surfactant spraying, high pressure jet spraying, etching and centrifugal spraying. Ultrasonic cleaning generates considerable noise at frequencies below 30 kilohertz; and, at higher frequencies of the order of 80-100 kilohertz and higher, surface features of semiconductor materials such as photoresist are likely to be damaged by the radiation field. Megasonic cleaning requires batch processing and does not allow continuous feed processing; and the solvent to be used must be chosen carefully; strong hydrofluoric acid and similar cleaning solutions cannot be used. Surface wiping is useful only for removal of larger contaminant particles and is not useful for cleaning irregular, non-planar surfaces; contaminant particles may be deposited on the surface from the solvent or the wiper itself. Brush scrubbing requires that the scrubbed parts be dried and the scrubbing solution or brush may deposit contaminants or unwanted thin films on the surface, especially a hydrophilic surface; and only one side or surface can be cleaned at a time. Low pressure surfactant spraying must rely on detergent action of the spray solution itself as the pressure used, typically 5-80 psi * , is insufficient by itself to remove contaminant particles. High pressure jet spraying relies on liquid jet velocities of 100-4000 psi, which requires that the article to be cleaned be securely anchored and precludes use of such spraying on surfaces with non-robust features.

Surface etching requires use and continuing replacement of special liquid solutions that form soluble complexes on the surface; "replating" of the surface is sometimes a problem, and etching is a multi-step, time consuming process. Centrifugal spray cleaning relies on a combination of centrifugal force and high pressure spraying and has many of the same problems as high pressure spraying.

A method for contamination removal of particles from a silicon wafer surface, using freezing of a small layer of water or other similar fluid on the surface, is disclosed in U.S. Pat. No. 4,777,804, filed August 26, 1987 and issued to Bowling et al. The contaminant particle is surrounded by a layer of liquid that grows in volume as the liquid freezes, thus moving the contaminant particle away from the surface. The frozen layer of liquid plus contaminants is then removed from the surface by brush scrubbing or some other technique that does not allow warming of the frozen layer.

The following Table I presents the current state of the art of methods for surface particle removal:

* 1 psi = 0.069 bar

Table I.  Comparison of cleaning process features.

| METHOD | CLEANING MECHANISM | LOWER LIMIT PARTICLE SIZE | GENERAL CHARACTERISTICS |
|---|---|---|---|
| ultrasonic | cavitation | 25 μm | frequency range of 18 to 100 kilohertz; may damage surface |
| megasonic | high pressure, waves | 0.2 μm | frequency range 8/10 to 1 megahertz; 15 minutes duration |
| wiping | shear | 5 μm | time-consuming |
| brush scrubbing | mechanical and shear | 0.5 μm | does not work well on hydrophilic surface |
| low pressure spray | mechanical and detergency | 0.2 μm | pressure range of 5 to 80 pounds per inch; relatively time-consuming |

* 1 pound per inch = 0.453 kg per 2.54 cm

| high pressure spray | shear | 0.2 μm | pressure range of 100 to 4,000 psi; relatively slow; can damage surface |
| --- | --- | --- | --- |
| etching | oxidation and dissolution | | high pH solutions oxidize organic contaminants; low pH solutions desorb metals; time-consuming |
| centrifugal spray | centrifugal shear and solvency | | series of fine sprays sprays at 2,500 psi; harmful chemicals; time-consuming |

Each of the cleaning methods heretofore discussed requires either the use of an active mechanical component, the use of special chemical solutions, or labor-intensive human participation in order to achieve a satisfactory level of effectiveness. Furthermore, each cleaning method discussed is limited to a particular classs of media to be cleaned, and, given the stringent requirements of certain industries, the absolute cleaning effectiveness of each method is not yet at a uniform, commercially acceptable level.

An object of the invention is to devise a technique that is relatively simple and removes small contaminant particles, of sizes down to 0.1 μm and even below this, from planar surfaces and from surfaces with vertical depressions or trenches therein.

This object is solved by the method of independent claims 1 and 2 and the system of independent claim 14. Further advantageous features of the invention are evident from the dependent claims, the description and the drawings. The claims are intended to be understood as a first non-limiting approach of defining the invention in general terms.

The invention meets the above needs by submerging the designated surface of an article in a cleaning liquid so that the surface to be cleaned is exposed to the liquid. A dissolving gas at high pressure is then dissolved in the cleaning liquid, and the gas pressure above the liquid is quickly reduced to a much lower pressure. Bubbles form in the cleaning liquid in response to the abruptly lowered gas pressure. Some of these bubbles form adjacent to contaminant particles, dislodging them and carrying such particles away from the designated surface of the article to be cleaned. In another embodiment, a layer of the cleaning liquid adjacent to the designated surface of the submerged article is frozen after the dissolving gas is dissolved in the cleaning liquid at an elevated pressure and before the gas pressure above this layer is abruptly reduced. Freezing helps to separate and remove particles from the designated surface.

The invention also has application in the manufacturing of precision optical components such as mirrors, lenses, laser windows and other components whose surfaces must be kept clean to prevent scattering of light therefrom, initiation of bulk or surface optical damage, and general degradation of optical performance. The invention may also be applied in the pharmaceutical and biotechnology industries, where particulate matter above a given size must be removed from surfaces or liquids during the manufacturing process.

This approach is especially useful for removing contaminants from trenches and other depressions in a non-planar surface such as an integrated circuit that has trenches and other depressions resulting from etching of, or growth on, selected parts of the wafer. These trenches may have transverse dimensions of the order of 0.5-5 μm that removal of contaminant particles from such a trench or other depression may be difficult or impossible using any of the well known techniques from the prior art.

Figure 1 is an elevation view of an apparatus useful in surface cleaning in accord with the invention.

Figures 2 and 3 are schematic views illustrating bubble formation under a contaminant particle and around a contaminant particle, respectively.

Figure 4 is an elevation view of a second embodiment of apparatus useful in surface cleaning in accord with the invention.

Figure 5 is an elevation view of a third embodiment of apparatus useful in surface cleaning in accord with the invention.

Figure 6 is an elevation view of a fourth embodiment of apparatus useful in surface cleaning in accord with the invention.

Figure 7 is a diagram showing a variant method of particle removal in accord with the present invention.

Figure 8 is an elevation view of a fifth embodiment of apparatus suitable in surface cleaning in accord with the invention.

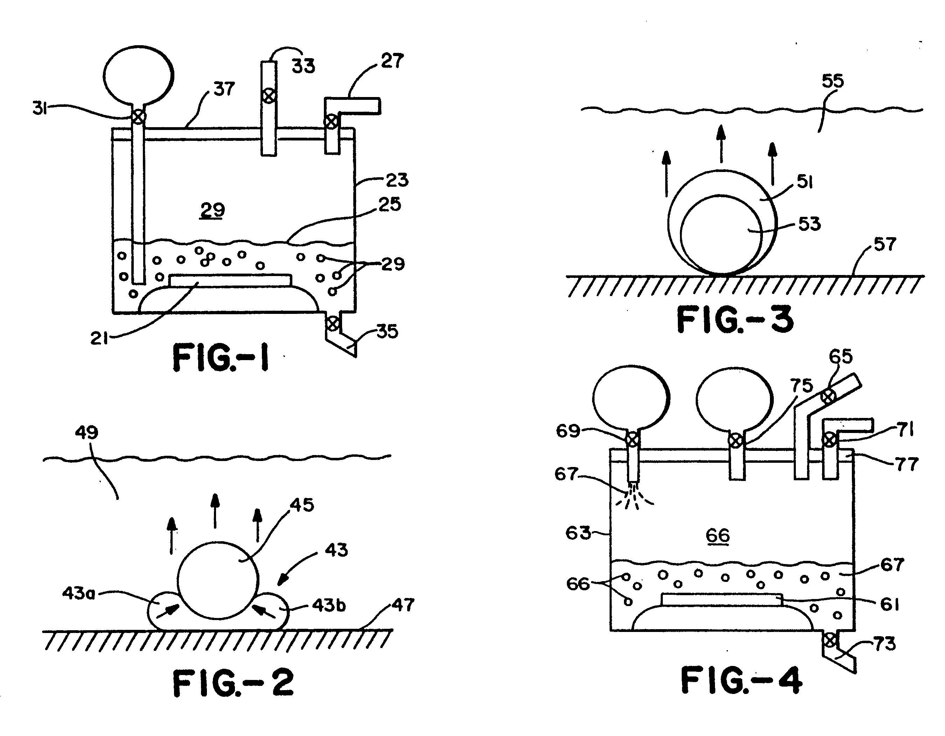

With reference to Fig. 1, the article 21 is placed in a pressure vessel chamber 23. De-ionized and filtered water or some other suitable cleaning liquid 25 is then introduced into the vessel 23 through a valve 27 until the article 21 is completely submerged in the liquid 25. The chamber 23 should not be completely filled with the cleaning liquid 25. A dissolving gas 29 is then bubbled through or otherwise introduced into the cleaning liquid 25 by opening a pressure valve 31 until a first desired gas pressure $p_1$ is reached. A portion of the dissolving gas 29 thus introduced will be dissolved into the cleaning liquid 25, with the amount of gas thereby dissolved increasing with increasing gas overpressure in the pressure vessel chamber 23. The dissolving gas 29 is continually introduced into the chamber 23 until a sufficient amount of this gas is dissolved in the cleaning liquid 25 and equilibrium is established between the pressure of the gas dissolved in the cleaning liquid 25 and the gas pressure in the remainder of the pressure vessel chamber 23. In order to dissolve an appreciable amount of the dissolving gas 29 in the cleaning liquid 25 the first gas pressure $p_1$ should be many times the atmospheric pressure, for example, $p_1 = 150\text{-}3000$ psi. A dissolving gas pressure of at least 150 psi is appropriate here.

A pressure relief valve 33 on the pressure vessel is then suddenly opened. The dissolving gas pressure in the portion of the pressure vessel 23 that is not submerged in the cleaning liquid 23 drops quickly from the first pressure $p_1$ to a second, much lower pressure $p_2$, preferably in a time interval of the order of one second or less. The second gas pressure $p_2$ may be approximately atmospheric pressure or may be some other pressure above or below atmospheric pressure.

As a result of the precipitous drop in dissolving gas pressure in the chamber 23 above the cleaning liquid 25, bubbles form in the cleaning liquid 25 and rise toward the liquid surface 26, propelled by the buoyant force of the bubble in relation to the surrounding cleaning liquid 25. A bubble can most easily form in the cleaning liquid 25 around a nucleus such as a contaminant particle that lies adjacent to the surface of the article 21 or is suspended in the liquid 25. Thus, many of the bubbles thus formed will contain contaminant particles that have acted as nuclei for formation of these bubbles. The bubbles thus formed carry the enclosed contaminant particles toward the upper surface of the cleaning liquid 25 within the pressure vessel chamber 23 so that these contaminant particles can be captured and removed. After the contaminant particles are removed, the remainder of the cleaning liquid may be drained from the pressure vessel by opening a drain 35 therein. The article 21 may be dried by directing dry nitrogen, helium, neon, argon, air or some other suitable dry gas at the surfaces of the article to remove all traces of the cleaning liquid 25 from such surfaces. A pressure vessel cover 37 may then be opened and the article 21 may be removed.

Two mechanisms of bubble formation and levitation are illustrated in Figs. 2 and 3. In Fig. 2, a single bubble 43, having a left lobe 43a and a right lobe 43b, is seen to form in the space between the contaminant particle 45 and the adjacent surface 47. The relatively high gas pressure within the bubble 43 having the shape shown in Fig. 2, then pushes the contaminant particle 45 away from the surface 47 in a reaction between the surface tension and internal pressure forces associated with the bunbble. As the contaminant particle 45 is pushed away from the designated surface 47, the adhesion force that exists between this particle and this surface is decreased substantially, and the contaminant particle 45 becomes substantially free to rise to the top of the surrounding liquid 49, propelled by the buoyant force of the bubble 43.

In Fig. 3, a bubble 51 first forms around a contaminant particle 53 that serves as a nucleus for such bubble. It is assumed here that the maximum diameter of the contaminant particle 53 is less than the equilibrium diameter of the bubble 51 that surrounds or encapsulates the contaminant particle. After the bubble 51 has formed around the contaminant particle 53, the buoyant force on the bubble/contaminant particle combination will cause this combination to move away from the adjacent designated surface 57. The adhesion force between contaminant particle 53 and surface 57 is reduced, allowing the combined bubble 51 and contaminant particle 53 to ascend toward an upper surface of the liquid 55.

The precise manner in which these bubbles form in a pressurized cleaning liquid will vary with the surface tension of the liquid, the surface properties of the particle and the partial pressure of the gas dissolved in the cleaning liquid 55. A hydrophobic particle surface might cause a bubble to form differently than a hydrophilic contaminant particle surface in Fig. 3. Irrespective of the manner in which the bubble 51 is formed, the buoyant force exerted by the bubble on the contaminant particle 53 will be high enough to cause the contaminant particle to separate from the surface, provided a sufficiently high partial pressure of the dissolved gas is used in the system.

In a second embodiment of the invention, shown in Fig. 4, the article 61 to be cleaned is first placed in a pressure vessel 63, with the designated surface to be cleaned being exposed. The system is pressurized by opening a gas valve 65 until the pressure vessel is completely filled with a predetermined dissolving gas 66, such as dry nitrogen, helium, neon, argon or air at a first gas pressure $p_1$. Next, de-ionized and filtered water or some other suitable cleaning liquid 67 is sprayed into the pressure vessel through an activatable spray nozzle at valve 69. As the cleaning liquid 67 is sprayed into the pressure vessel, numerous droplets of the cleaning liquid 67 are formed. As these droplets fall through the gas within the pressure vessel 63, a portion of the gas 66 is dissolved into the droplets at an increased rate, relative to dissolution of the dissolving gas 66 into a large body of the cleaning liquid 67 as contemplated in Fig. 1. After sufficient cleaning liquid 67 has been sprayed into the pressure vessel 63, the article 61 to be cleaned is submerged in the cleaning liquid 67. Equilibrium is established between the partial pressure of the gas dissolved in the cleaning liquid 67 and the dissolving gas 66 in the remaining volume of the pressure vessel 63. An outlet valve 71 in the pressure vessel is suddenly opened and the gas pressure in the pressure vessel 63 is quickly reduced from the first gas pressure $p_1$ to a second, lower gas pressure $p_2$ that may be approximately atmospheric pressure. The sudden reduction in gas pressure within the pressure vessel 63, which preferably takes place in a time interval of the order of one second or less, causes spontaneous formation of bubbles of the dissolved gas 66 within the cleaning liquid 67. Many of these bubbles carry contaminant particles to the surface by one or the other of the mechanisms illustrated in Figs. 2 and 3. After the contaminant particles have been lifted toward the upper surface of the cleaning liquid 67 by the bubbles, the contaminant particles are removed and the remaining cleaning liquid is drained by opening a liquid outlet valve 73 to drain the pressure vessel 63. The article 61 may then be dried by directing dry nitrogen, helium, neon, argon, air or other suitable, dry, relatively inert gas from a drying gas source 75 at the article to remove any remaining cleaning liquid from the surfaces of the article 61. A cover 77 on the pressure vessel 63 may then be removed and the article 61 may be removed for further processing.

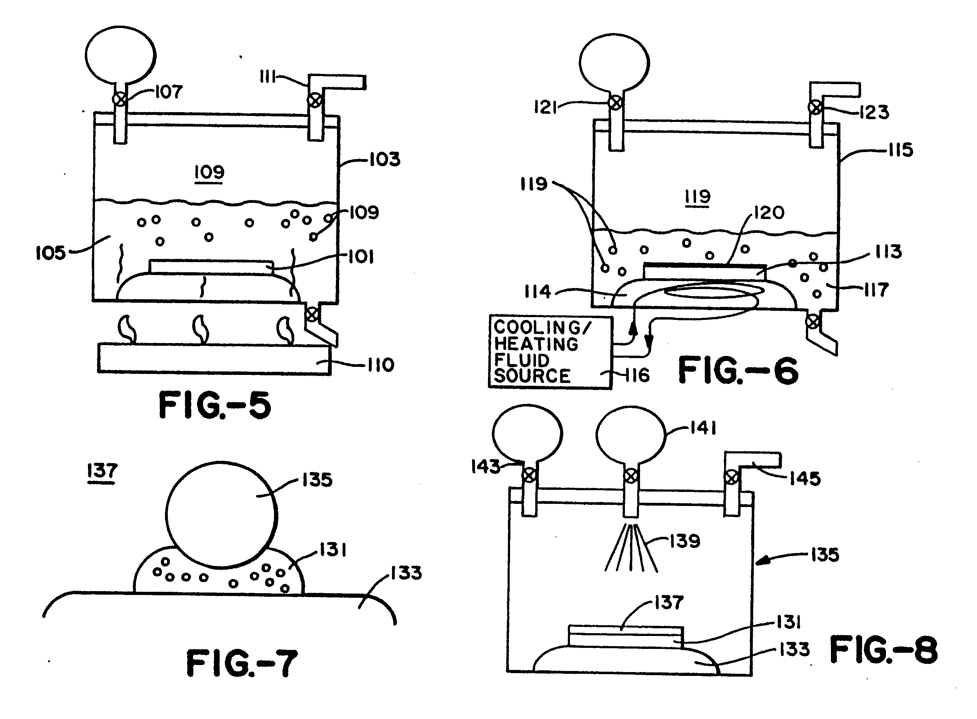

In another embodiment of the invention, illustrated in Figure 5, the article 101 to be cleaned is placed in a pressure vessel chamber 103 and the chamber is filled with a cleaning liquid 105 so that the article 101 is submerged in the liquid as before, with some chamber volume remaining that is not filled with the liquid. An inlet valve 107 in the chamber 103 is then opened, and the interior of the chamber 103 is pressurized with a dissolving gas 109 at some high pressure $p_1$ of the order of 150 psi or greater. After equilibrium is established in the chamber 103, a substantial portion of the dissolving gas 109 is dissolved in the cleaning liquid (still indicated as 105). The cleaning liquid 105 is now heated to a predetermined temperature $T_1$ that is much greater than $T_{room}$. In fact, $T_1$ may be chosen greater than the boiling temperature $T_{boil}$ for the cleaning liquid 105 at atmospheric pressure, but below $T_{boil}$ at the higher pressure $p_1$. The high gas pressure present in the chamber 103 will ensure that substantially no boiling takes place and that the cleaning liquid 105 remains as a liquid. At this point, a pressure relief valve 111 is suddenly opened, and the pressure within the pressure vessel chamber 103 drops quickly to a second, lower, predetermined gas pressure $p_2$ that may be atmospheric pressure or higher or lower. The sudden reduction in chamber pressure again causes bubbles to form spontaneously in the cleaning liquid 105, with increased vigor due to the elevated temperature of the cleaning liquid 105, and the contaminant particles on the surface of the article 101 are carried toward the upper surface of the cleaning liquid 105, thereby removing the contaminant particles from the surface of the article 101. The choice of elevated temperature $T_1$ is arbitrary here, but it may be preferable to choose $T_1$ less than $T_{boil}$ so that most or all of the cleaning liquid 105 remains as a liquid and is not boiled away when the gas pressure within the pressure vessel chamber 103 is dropped from $p_1$ to $p_2$. The choice of elevated temperature $T_1$ may also be constrained by the need to choose a temperature that does not damage the article 101 or its surface, which is in contact with the cleaning liquid 105 at the elevated temperature. The embodiment of the invention illustrated in Figure 5 may also be used to remove contaminant particles from a liquid, where the need to avoid damage to the article at an elevated temperature is no longer a consideration.

Another embodiment of the invention, illustrated in Figure 6, utilizes a cleaning liquid at a reduced temperature $T$ which is less than $T_{freeze}$. The article 113 to be cleaned is placed in a pressure vessel chamber 115, and the chamber is partially filled with a cleaning liquid 117 so that the article is submerged, but the chamber volume is not completely filled with the cleaning liquid 117. An inlet valve 121 in the pressure vessel chamber 115 is then opened and the interior of the chamber is pressurized with a dissolving gas 119 to a predetermined gas pressure $p_1$. After equilibrium is established within the chamber 115, a portion of the dissolving gas 119 is absorbed in the cleaning liquid (still indicated as 117), and the remainder of the chamber volume contains the dissolving gas at a pressure $p_1$. The temperature of the cleaning liquid 117 is now lowered to a temperature $T_2$ below its freezing temperature $T_{freeze}$, and a thin layer 120 of the cleaning liquid 117 is frozen onto the exposed designated surface of the article 113 that is to be cleaned. The temperature of the cleaning liquid 117 can be reduced to a temperature $T_2$ which is less than $T_{freeze}$ by any of several techniques. In one technique, cooling fluid from a cooling fluid source 116 is circulated through the article support 114 adjacent to the article. This cools the article 113 and the surrounding cleaning liquid to the desired temperature without necessarily freezing the remaining liquid 117 within chamber 115. In another approach, cooling gas from a cooling fluid source is introduced into the pressure vessel chamber 115, in the portion of the chamber volume that is not occupied by the cleaning liquid 117 or the article 113, and contact of this cooling gas with the cleaning liquid cools the cleaning liquid to a temperature $T_2$ which is less than $T_{freeze}$.

After a thin frozen layer 120 of thickness 0.1-100 $\mu$m of the cleaning liquid 117 has formed on the surface of the article 113, a pressure relief valve 123 in the pressure vessel chamber 115 is suddenly opened, and the chamber gas pressure is quickly reduced from the value $p_1$ to a lower value $p_2$, which may be atmospheric pressure or higher or lower. This sudden reduction in chamber gas pressure may cause the frozen layer 120, which contains the dissolved gas 119 at a pressure $p_1$ that is many times the normal atmospheric pressure, to undergo a phase change from its solid form, either to a liquid form or partly liquid form or to a gas form through sublimation. In any case, bubbles of the dissolved gas 119 spontaneously form in the layer 120 after the substance has undergone the phase change, and the bubbles thereby formed remove the contaminant particles from the designated surface of the article 113. Freezing of the cleaning liquid 117 with the bubbles therein may be advantageous for two reasons: (1) The freezing process further separates the contaminant particles from the surface of the article 113; and (2) When the frozen liquid recovers to its liquid state this occurs vigorously and this process helps propel the contaminant particles away from the surface.

In another embodiment of the invention, which makes use of the apparatus shown in Figure 6, after a thin frozen layer of the cleaning liquid has formed on the surface of the article 113, a small portion of this frozen layer that is contiguous to the surface of the article 113 is heated by a controllable amount by fluid source 116 to reconvert this portion of the frozen layer to liquid form. When the chamber gas pressure abruptly drops from $p_1$ to $p_2$, a phase change occurs in some or all of the remaining frozen layer of cleaning liquid 117 and bubbles spontaneously form in the liquid portion of the cleaning liquid that is contiguous to the designated surface of the article 113. Again, the bubbles formed move away from the designated surface of the article 113 and carry the contaminant particles with them so that the surface of the article 113 is thereby cleaned.

In yet another embodiment, illustrated schematically in Fig. 7, a very small amount of the cleaning liquid 131, which is assumed to have low or moderate surface tension, wets part or all of the designated surface of the article 133 to be cleaned; and the cleaning liquid 131 that is present is assumed to accumulate by capillary action or otherwise in the crevices formed between a contaminant particle 135 and the adjacent portion of the designated surface of the article 133. A dissolving gas 137 is now admitted to the chamber at a pressure $p_1$ that is many times atmospheric pressure, and a portion of the dissolving gas becomes dissolved in the cleaning liquid (still indicated as 131) in the crevices. An outlet valve for the chamber is suddenly opened, the pressure of the dissolving gas quickly drops from $p_1$ to a much lower value $p_2$, and a phase change occurs in the cleaning liquid 131 in the crevices that propels the contaminant particle 135 away from the surface of the article 133 for removal from the chamber by other means. Here, the cleaning liquid 131 should cover the designated surface of the article 133 to a depth of at most a small fraction of the characteristic diameter of one at the contaminant particles 135 to be removed.

The embodiments of the invention illustrated in Figures 1, 4, 5, 6 and 7 are useful in cleaning planar surfaces or non-planar surfaces that have many peaks and valleys therein. One useful application of this invention is in removing contaminant particles from trenches or other vertical depressions formed in a semiconductor chip or wafer surface during processing of the chip. The invention will remove contaminant particles down to and below 0.1 $\mu$m and may thus be useful in cleaning trenches that have transverse widths of the order of 0.5-10 $\mu$m, or even lower. Preferably, care should be taken to ensure that the cleaning liquid used thoroughly wets the surfaces of the trench so that any contaminant particles in the trench can be removed by the techniques disclosed in this application. Care should also be taken to remove the contaminant-bearing bubbles as these bubbles rise toward the upper surface of the liquid so that the contaminant particles do not sink back into the trenches if and when the bubbles burst.

Although the embodiments of the invention illustrated in Figs. 1, 4, 5, 6 and 7 indicate that the entire article is submerged in the cleaning liquid, the invention may also be practiced by providing only a thin layer of liquid on the surface to be cleaned, with the remainder of the article not being submerged in the cleaning liquid. One method of accomplishing this is illustrated in Fig. 8, where a wafer 131 is positioned on a pedestal 133 adjacent to one side of a chamber 135 that may be substantially evacuated. A layer 137 of the cleaning liquid may be deposited on an exposed surface of the article 131 by a spray 139 of such liquid directed at the article surface from a cleaning liquid source 141. The chamber 135 may also be provided with a gas source 143, positioned adjacent to the chamber to introduce therein a gas at high pressure, and a gas outlet valve 145 to quickly remove the gas from the chamber interior and thereby drop the chamber pressure rapidly. Provision of a laver 137 of cleaning liquid of thickness as small as ten $\mu$m on the surface of the article 131 to be cleaned should be sufficient to allow contaminant particles to be removed from the article surface by means of the liquid freeze and pressure drop processes discussed above.

The present invention is not restricted to the use of water as the cleaning liquid or to the use of nitrogen, helium, neon, argon or air as the dissolved gas. Other cleaning liquids, such as a mixture of water (85 percent or more by volume) with isopropyl alcohol, isobutyl alcohol or fluorocarbons, can be used for the cleaning liquid. Other gases can be used for the dissolving gas. A suitable dissolving gas should have appropriate solubility in the cleaning liquid, and the gas's physical and chemical properties should be compatible with the liquid and with the surface to be cleaned. In particular, it may be desirable in some circumstances to use a single substance, such as a fluorocarbon, with a suitable vapor pressure/temperature relationship. In this instance, the substance would be pressurized to form a liquid into which the surface to be cleaned is placed. The gas pressure in the pressure vessel would then be quickly reduced and a portion of the liquid would vaporize, forming bubbles around the contaminant particles and lifting the contaminant particles toward the upper surface of the remaining liquid. Particles are thereby removed.

## Claims

1. A method for removing contaminant particles from a designated surface of an article, the method comprising the steps of :
at least partially covering the designated surface of the article with a cleaning liquid within a pressure vessel chamber;
introducing a gas into the chamber at a first predetermined pressures to at least partially dissolve the gas in the cleaning liquid; and
reducing the chamber pressure to a second pressure that is lower than the first pressure so that bubbles form within the cleaning liquid and move the contaminant particles away from the designated surface of the article.

2. A method for removing contaminant particles from a designated surface of an article, especially according to claim 1, the method comprising the steps of :
supporting the article within a pressure vessel so that the designated surface is exposed;
providing a cleaning liquid within the chamber so that the designated surface is at least partially covered by the liquid;
dissolving a dissolving gas into the cleaning liquid at a first pressure;
rapidly dropping pressure in the pressure vessel to a second pressure lower than the first pressure to such an extent that bubbles spontaneously form within the liquid, whereby some of the bubbles can dislodge contaminant particles from the designated surface; and
removing the cleaning liquid.

3. The method of one of the preceding claims, further comprising the steps of :
choosing said cleaning liquid as de-ionized and filtered water; and
choosing said predetermined gas from a class of gases, which may be injected into and held in water at high pressures, consisting of air, nitrogen, helium, neon and/or argon.

4. The method of one of the preceding claims, further comrising the steps of choosing said first pressure as at least 150 psi ( 1 psi = 0.69 bar) and choosing said second pressure as approximately atmospheric pressure.

5. The method of claim 3 further defined by the step of :
freezing a layer of the cleaning liquid over said surface exposed before opening said chamber pressure.

6. The method of one of the preceding claims, further comprising the step of heating said cleaning liquid, which optionally may be frozen to the exposed layer before said pressure relief valve is openend.

7. The method of one of the preceding claims, wherein removing said dislodged contaminant particles comprises draining said cleaning fluid from said pressure vessel chamber and directing a drying gas at said article to remove substantially all of said cleaning fluid from said article.

8. The method of one of the preceding claims, further comprising the steps of choosing the height of said cleaning liquid above said designated surface as a small fraction of a representative diameter of a contaminant particle to be removed so that a portion of said cleaning liquid adjacent to said designated surface accumulates between said designated surface and an adjacent contaminant particle.

9. The method of one of the preceding claims, further comprising the step of choosing a predetermined depth of said cleaning liquid above said designated surface to be less than 100 $\mu$m.

10. The method of one of claims 5 to 9 wherein the step of causing said cleaning fluid that covers said designated surface to freeze and form a frozen layer on said designated surface to thereby contact contaminant particles that are adjacent to this surface comprises introducing a cooling gas, maintained at a temperature that is less than the freezing temperature of said cleaning liquid, into said pressure vessel chamber and allowing the cooling gas to contact the cleaning liquid and thereby lower the temperature of said cleaning liquid.

11. The method of one of claims 5 to 9, wherein said step of causing said cleaning liquid that covers said designated surface to freeze, comprises the steps of:

providing means for supporting said article within said pressure vessel chamber; and

circulating a cooling fluid maintained at a temperature that is less than the freezing temperature of said cleaning liquid, within the support means adjacent to said article to thereby lower the temperature of said designated surface and of said cleaning liquid adjacent to said designated surface.

12. The method of claim 10 or 11 further comprising the step of warming a sub-layer of frozen cleaning liquid adjacent to said designated surface so that a sub-layer of said frozen cleaning liquid is converted to liquid form, before said pressure relief valve is activated.

13. The method of one of the preceding claims, wherein said step of providing said cleaning liquid comprises spraying said cleaning liquid on said designated surface of said article so that said designated surface is covered with or submerged in said cleaning fluid.

14. A system for cleaning contaminant particles from a surface, especially for carrying out the method of one of the preceeding claims, comprising:

a. a pressure vessel (23), the pressure vessel being suitably configured so as to house the surface;

b. a source of a cleaning liquid (25);

c. fluid introduction means (27) for introducing the cleaning fluid (25) into the pressure vessel (23) to at least partially cover said surface;

d. a source of gas (29) for pressurizing the pressure vessel (23) interior at a predetermined pressure such that some of said gas (29) is dissolved into said cleaning fluid (25);

e. means (33) for rapidly decreasing the gas pressure within the pressure vessel (23) to a lower gas pressure such that bubbles of said gas form within the cleaning fluid; and

f. means (35) for removing the cleaning fluid from the pressure vessel.

15. The system of claim 14, wherein said cleaning liquid (25) is de-ionized and filtered water and said gas (29) is chosen from a class of gases, which may be injected into and held in water at high pressures, consisting of air, nitrogen, helium, neon and/or argon.

16. The system of claim 14 or 15, wherein said predetermined gas pressure (P1) is at least 150 psi (1 psi = 0.69 bar) and said lower gas pressure (P2) is approximately atmospheric pressure.

17. The system of one of claims 14 to 16, further comprising means (110, 116) for heating said cleaning liquid (25) in said pressure vessel (23) before said gas pressures is decreased from said predetermined gas pressue (P2).

18. The system of one of claims 14 to 17, further comprising freezing means (116) for freeezing a layer (120) of said cleaning liquid over said surface so that the frozen layer of cleaning liquid contacts contaminant particles on said surface.

19. The system of claim 18, wherein said freezing means includes a source (116) of cooling gas and includes means for introducing the cooling gas into said pressure vessel so that the cooling gas contacts said cleaning liquid and thereby lowers the temperature of said cleaning liquid in said pressure vessel.

20. The system of claim 18, wherein said freezing means comprises:

support means (114) for supporting said article within said pressure vessel;

a source (116) of cooling fluid; and

means for circulating the cooling fluid within the support means adjacent to said article to thereby lower the temperature of said article and of said cleaning liquid adjacent to said surface.

21. The system of one of claims 14 to 16 wherein said fluid introduction means includes spraying means for spraying (139) said cleaning liquid onto said surface so that said surface is covered with or submerged in said cleaning liquid.

FIG.-1

FIG.-2

FIG.-3

FIG.-4

FIG.-5

FIG.-6

COOLING/ HEATING FLUID SOURCE

FIG.-7

FIG.-8

EP 0 428 983 A2